# EUROPEAN PATENT APPLICATION

(11) **EP 4 250 456 A1**
(43) Date of publication of application: **27.09.2023**
(21) Application number: 22759952.9
(22) Date of filing: 11.02.2022
(51) Int. Cl.: H01M 50/284

(54) **BATTERY PACK INCLUDING PCM HAVING CONNECTION STRUCTURE DIRECTLY JOINED WITH BATTERY CELL**

(30) Priority: 23.02.2021 KR 20210024314
(71) Applicant: LG Energy Solution, Ltd., Seoul 07335 (KR)
(72) Inventor: KIM, Sang Jin, Daejeon 34122 (KR); LEE, Jin Hyun, Daejeon 34122 (KR); JANG, Jae Young, Daejeon 34122 (KR); JUNG, Dae Ho, Daejeon 34122 (KR)
(74) Representative: Goddar, Heinz J.
(86) International application number: PCT/KR2022/002115
(87) International publication number: WO 2022/182034

(57) **Abstract**

In accordance with an exemplary embodiment, a connection structure between a battery and a PCM is characterized in that in a battery pack in which a battery cell is connected to the PCM, the battery cell includes: a battery cell main body; and an electrode lead tab electrically connected with the battery cell main body, a PCB of the PCM includes: an insulation board; a second copper foil layer brought into contact with a top surface of the insulation board; a first copper foil layer formed above the second copper foil layer; and a first prepreg layer disposed between the first copper foil layer and the second copper foil layer, and the electrode lead tab of the battery cell is directly bonded to the first copper foil layer of the PCM. As the battery cell is directly bonded to the PCM without a separated connection member, a simple connection structure is provided, and process efficiency is improved.

## Description

### TECHNICAL FIELD

The present disclosure relates to a PCM having a direct junction structure with an electrode lead tab of a battery cell and a battery pack including the same, and more particularly, to a PCB having a direct junction structure with an electrode lead tab of a battery cell without a connection member by mixing carbon black having a high absorptance at a wavelength band of laser used during a bonding process in a prepreg layer of the PCB of a PCM and a battery pack including the same.

### BACKGROUND ART

In recent years, as a demand for a mobile electronic device and an eco-friendly vehicle increases, a demand for a secondary battery used as an energy source also significantly increases, and researches and developments related to high performance, high efficiency, and high stability secondary battery are actively performed. A lithium secondary battery that is light and has high energy density and excellent preservation and lifespan features is widely used.

Since the secondary battery contains all sorts of combustible materials, safety issues such as ignition or explosion caused by over-charging, over-discharging, over-current, heating, and consecutive side reactions exist. Thus, the secondary battery is protected by safety elements capable of continuously detecting and controlling a voltage, a current, and a temperature of each of unit cells such as a positive temperature coefficient (PTC) element, a protection circuit module (PCM), and a thermal cut-out (TCO). The safety elements, e.g., elements of the PCM, are disposed on a printed circuit board (PCB), on which a circuit electrically connected to an electrode terminal of each of the safety elements is disposed, and electrically connected to a battery cell main body as the PCB is mounted or attached to an outer portion of the battery cell main body. Thus, a welding method for bonding an electrode lead tab of the battery main body to one surface of the PCB is widely used to connect the PCB to the battery cell main body.

A first copper foil layer made of copper that is a conductive material is disposed on one surface of the PCB to be electrically connected with a protection circuit and a battery cell. When the first copper foil layer of the PCB is directly welded and bonded to the electrode lead tab of the battery cell in a connection structure of the battery cell and the PCB of the related art, used laser damages the inside of the PCB while transmitting therethrough. Thus, a bent metallic connection member is separately mounted on the first copper foil layer of the PCB, and then the battery cell lead is welded onto the connection member to block the laser, or the electrode lead tab of the battery cell is welded to the PCB so that the laser is not directly irradiated to the PCB. Thus, the number of processes increases, and a thickness of a welded portion increases due to formation of the separate connection member.

The background technology of the present disclosure is disclosed in patent documents below.
(Patent document 1) JPWO2014-020896 A1
(Patent document 2) KR2009-0039053 A
(Patent document 3) JP1996-034864 A
(Patent document 4) KR2018-0084462 A

### DISCLOSURE OF THE INVENTION

### TECHNICAL PROBLEM

The present disclosure provides a direct junction structure between a PCB of a PCM and an electrode lead tab of a battery cell in the PCB bonded with the battery cell and a battery pack in which the battery cell is connected with the PCM as described above.

### TECHNICAL SOLUTION

In accordance with an exemplary embodiment, in a battery pack in which a battery cell is connected to a PCM, the battery cell includes: a battery cell main body; and an electrode lead tab electrically connected with the battery cell main body, a PCB of the PCM includes: an insulation board; a second copper foil layer brought into contact with a top surface of the insulation board; a first copper foil layer formed above the second copper foil layer; and a first prepreg layer disposed between the first copper foil layer and the second copper foil layer, and the electrode lead tab of the battery cell is directly bonded to the first copper foil layer of the PCM.

The direct bonding between the electrode lead tab of the battery cell and the PCM may be formed by laser welding.

The first prepreg layer may include a material having a high absorptance at a wavelength band of laser used in the laser welding.

The material having the high absorptance at the wavelength band of the laser used in the laser welding and contained in the first prepreg layer may be carbon black.

The PCB may include: a third copper foil layer brought into contact with a bottom surface of the insulation board; a fourth copper foil layer disposed below the third copper foil layer; and a second prepreg layer disposed between the third copper foil layer and the fourth copper foil layer, and the second prepreg layer may include carbon black.

In accordance with another exemplary embodiment, provided is a battery pack including the PCM having the connection structure of one of the battery packs.

### ADVANTAGEOUS EFFECTS

The battery pack in accordance with the exemplary embodiment includes the battery cell, the electrode lead tab electrically connected with the battery cell, the PCM boned with the battery cell, and the PCB contained in the PCM, and the PCB includes the first prepreg layer in which the carbon black is mixed between the first copper foil layer and the second copper foil layer. Since the laser irradiated during the process of bonding the electrode lead tab of the battery cell and the first copper foil layer of the PCB is absorbed by the carbon black instead of being transmitted to the bottom surface of the first prepreg layer, the inner layer of the PCB and the protection circuit element may be prevented from being damaged by the laser. As a result, the bonding process of directly irradiating the electrode lead tab of the battery cell and the first copper foil layer of the PCB with the laser even without the separate connection member used in the related art may be performed. Thus, the simple bonding process may improve the process efficiency and form the connection structure between the battery cell and the PCB.

### BRIEF DESCRIPTION OF THE DRAWINGS

FIG. 1 is a cross-sectional view illustrating a PCM including a connection member in the related art.
FIG. 2 is a perspective view illustrating a battery pack having a connection structure including the connection member in the related art.
FIG. 3 is a cross-sectional view illustrating the battery pack including the connection member in the related art.
FIG. 4 is a perspective view illustrating a battery pack having a connection structure in accordance with an exemplary embodiment.
FIG. 5 is a cross-sectional view illustrating the battery pack having the connection structure in accordance with an exemplary embodiment.
FIG. 6 is a cross-sectional view illustrating a PCM excluding the connection member in accordance with an exemplary embodiment.

### MODE FOR CARRYING OUT THE INVENTION

Hereinafter, exemplary embodiments of the present invention will be described in detail with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art. In the figures, the dimensions of layers and regions are exaggerated for clarity of illustration. Like reference numerals refer to like elements throughout.

Hereinafter, exemplary embodiments will be described with reference to the accompanying drawings.

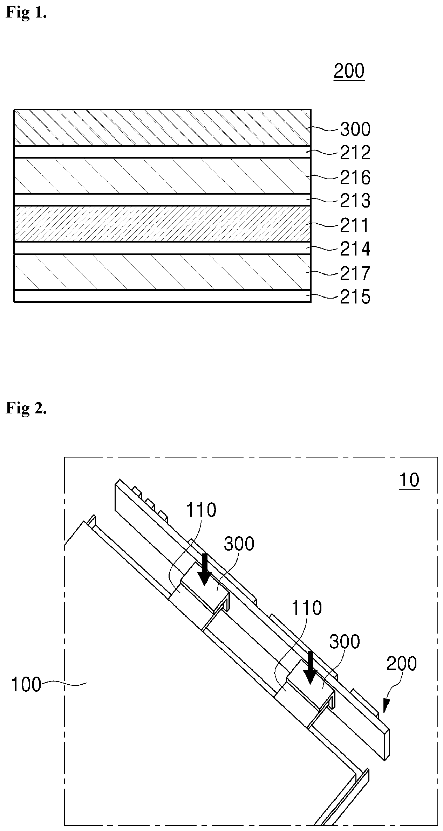

Referring to FIG. 1, a battery pack in accordance with an exemplary embodiment includes a battery cell 100, an electrode lead tap 120 electrically connected to the battery cell 100, a PCM 200, and a PCB 210 contained in the PCM, and the PCB 210 includes a prepreg layer in which carbon black is mixed.

### 1. Configuration of battery pack in accordance with exemplary embodiment

### A. Battery cell 100

### (1) Battery cell main body 110

In general, a battery cell main body 110 is configured such that a positive electrode plate and a negative electrode plate, which are respectively coated with a positive active material and a negative active material, are disposed with a separator therebetween and sealed in a battery case with an electrolyte.

### (2) Electrode lead tab 120

The electrode lead tab 120 may be formed on one surface of the battery case. In particular, the electrode lead tab 120 may be electrically connected to the positive electrode plate and protrude to the outside of the battery case, and the battery cell main body 110 may be electrically connected with the PCM 200 by the electrode lead tab 120. Also, the electrode lead tabs 120 respectively connected to the positive electrode and the negative electrode plate may protrude in parallel from one surface of the battery case or be respectively disposed on both surfaces of the battery case according to a battery structure and a shape of the battery case.

### B. Protection circuit module (PCM) 200

The PCM 200, as one kind of safety element of the secondary battery pack, continuously detects a voltage and a temperature of a current of each of the battery cells 100 and performs a control function to protect the battery cells 100 from the risk of ignition or explosion caused by over-charging, over-discharging, over-current, heating and consecutive side reactions of the battery cell 100. The PCM 200 is mounted to the PCB 210 on which a circuit electrically connected with an electrode terminal of the PCM 200 is printed and electrically connected with the battery cell 100 through the electrode lead tab 120 of the battery cell bonded with the PCB 210.

### (1) Printed circuit board (PCB) 210

The PCB 210 represents a board in which a circuit containing a conductive material such as copper is printed on a board made of an electrically insulating material. Protection circuit elements used in the secondary battery may be mounted to the PCB 210 and electrically connected to the battery cell 100 through the electrode lead tab 120 of the battery cell 100 connected with the PCB 210.

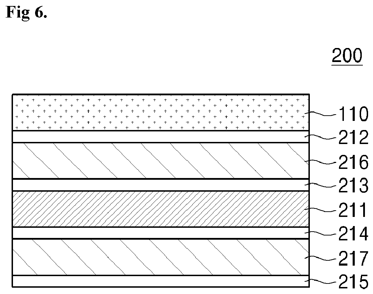

Hereinafter, an exemplary embodiment will be described with reference to FIGS. 1 and 6. FIG. 1 is a cross-sectional view illustrating the PCM 200 including a connection member 300 as the related art.

FIG. 6 is a cross-sectional view illustrating the PCB 210 in accordance with an exemplary embodiment. The PCM 200 in accordance with an exemplary embodiment includes carbon black in a first prepreg layer that will be described later except for the connection member 300.

The PCB 210 may include a single side PCB, a double side PCB, or a single-layer/multilayer PCB according to the arrangement position and the laminated number of a copper foil layer.

### 2.1.1 Insulation board 211

An insulation board 211 is made of a thermosetting resin such as CEM-1 and CEM-3 that are glass fiber materials, or FR-4 in which an epoxy resin is impregnated to glass fiber to exhibit an insulating property and configure the PCB 210. In general, the PCB 210 includes a single side or double side single-layer PCB in which a wiring circuit is formed on one surface or both surface of the insulation board 211. The PCB 210 in which two or more copper foil layers are formed on one surface is referred to as a multilayer PCB. Although double surface multilayer PCB is exemplified in FIGS. 1 and 6, the exemplary embodiment is not limited thereto.

### 2.1.2 First copper foil layer 212

As a copper foil layer formed on a copper foil formed on one surface of the insulation board 211 to configure a circuit, the first copper foil layer 212 is connected to the components mounted on the PCB 210 through a printed circuit and electrically connected with the battery cell 100 through the electrode lead tab 120. In a connection structure of an exemplary embodiment, the first copper foil layer 212 forms a direct junction structure with the electrode lead tab 120 of the battery cell 100 without the separate connection member 300 and is formed on a second copper foil layer 312 that will be described later.

### 2.1.3 Second copper foil layer 213

The second copper foil layer 213 is formed on a top surface of the insulation board 211 to configure a circuit. In case of the related art, when laser welding is performed in an assembling process of bonding the first copper foil layer 212 with the electrode lead tab 120, laser directly irradiated to the PCB 210 forms a bonded portion and then is transmitted to an inner layer of the PCB 210 to damage the second copper foil layer 213. The second copper foil layer 213 contacts the insulation board 211 below the first copper foil layer 212.

### 2.1.4 Third copper foil layer 214

The third copper foil layer 213 contacts a bottom surface of the insulation board 211 to configure a circuit. In case of the related art, when laser welding is performed in the assembling process of bonding the first copper foil layer 212 with the electrode lead tab 120, the laser directly irradiated to the PCB 210 forms a bonded portion and then is transmitted to the inner layer of the PCB 210 to damage the second copper foil layer 213 and the third copper foil layer 214.

### 2.1.5 Fourth copper foil layer 215

The fourth copper foil layer 215 is formed below the third copper foil layer 214 formed on the bottom surface of the insulation board 211 to configure a circuit. The fourth copper foil layer 215 is connected through a printed circuit, and protection circuit elements 220 are disposed thereon. In case of the single side PCB, the third and fourth copper foil layers may be omitted.

### 2.1.6 First prepreg 216

### i) Related art

The prepreg forms the insulation board 211 of the PCB 210 in a semi-cured state in which epoxy resin is impregnated to glass fiber or is used as an insulation adhesive for laminating the copper foil layer on the single side PCB in the multilayer PCB structure. Laser used when the electrode lead tab 120 of the battery cell 100 is welded to the first copper foil layer 212 of the PCB 210 uses a wavelength band of 1070 µm, and the prepreg including the glass fiber and the epoxy resin exhibits an optical feature of high transmittance at the wavelength band of the laser. Thus, when the laser is directly irradiated to a top surface of a bonded portion in order to bond the electrode lead tab 120 of the battery cell to the first copper foil layer 212, the inner layer of the PCB 210 including the first copper foil layer 212 and the second and third copper foil layers and the protection circuit elements 220 mounted to a lower portion of the insulation board 211 may be damaged by the transmitted laser.

Thus, although the separate metallic connection member 300 such as nickel is additionally applied and bonded so that the laser is not directly irradiated to the top surface of the PCB 210 to prevent the inner layer of the PCB 210 from being damaged by the laser in the related art, a manufacturing process is complicated due to addition of the connection member 300, and the bonded portion increases in thickness.

### ii) First prepreg layer 216 in accordance with exemplary embodiment

The first prepreg 216 is disposed between the first copper foil layer 212 and the second copper foil layer 213.

The prepreg in accordance with an exemplary embodiment forms the insulation board 211 by additionally mixing carbon black to epoxy in the process of manufacturing the PCB 210 and form the copper foil layer on one surface or both surfaces of the formed insulation board 211 to manufacture the single-layer PCB. The multilayer PCB may be manufactured by additionally laminating the copper foil layer on the formed single-layer PCB using the prepreg as an insulation adhesive, and the prepreg in accordance with an exemplary embodiment may be used by mixing carbon black therein. The laser irradiated to the PCB 210 in the bonding process bonds the electrode lead tab 120 and the first copper foil layer 212, and residual laser is transmitted to the first prepreg layer. Since the carbon black mixed in the prepreg in accordance with an exemplary embodiment has a feature of a high absorptance at the laser wavelength band used in the process of bonding the electrode lead tab 120 of the battery cell 100, the residual laser irradiated to the PCB 210 is absorbed by the carbon black of the first prepreg layer 216. Thus, since an amount of the laser transmitted through is reduced by the first prepreg layer 216, the damage of the inner layer of the PCB 210 caused by the laser may be prevented.

Since the carbon black has a feature of a low electrical conductivity and a high light absorptance, the carbon black may be mixed in the prepreg used when laminating the copper foil or the insulation board 211 of the PCB 210 to maintain an insulation property and also absorb the laser used in a process of welding the electrode lead tab 120 and the first copper layer 212. Thus, since the PCB 210 in which the carbon black is mixed in the first prepreg layer 216 prevents damage in the inner layer of the PCB 210 caused by the laser even without the separate connection member 300, a bonding process of directly irradiating laser to a bonded portion between the electrode lead tab 120 of the battery cell 100 and the first copper foil layer of the PCB 210 may be performed to form a simple connection structure between the PCB 210 and the battery cell through a simple process.

### iii) Second prepreg layer 217 in accordance with exemplary embodiment

When the multilayer PCB is applied to a bottom surface of the double side PCB, the second prepreg 217 is disposed between the third and fourth copper foil layers.

The second prepreg 217 may include the carbon black as same as the first prepreg 216 and further effectively prevent the protection circuit elements 220 mounted to the bottom surface of the PCB 210 from being damaged by the laser.

### (2) Protection circuit element (PCM element) 220

The protection circuit element 220 may be passive or active elements including a protection circuit and mounted to upper or lower portions of the PCB 210. A plurality of protection circuit elements 220 may be laminated. Also, the protection circuit element 220 protects the battery cells from the risk of ignition or explosion caused by over-charging, over-discharging, and over-current heating of the battery cell and consecutive side reactions When the protection circuit elements 200 are mounted to the lower portion of the PCB 210, the protection circuit elements 200 may be damaged by the laser transmitted through the PCB 210 during laser welding in accordance with the related art. However, the PCB 210 in accordance with an exemplary embodiment may absorb/shield the laser by the first prepreg layer 216 in which the carbon black is mixed and the second prepreg layer 217 when the carbon black is mixed to prevent the protection circuit elements 200 from being damaged by the laser.

### 2. Battery pack connection structure in accordance with exemplary embodiment

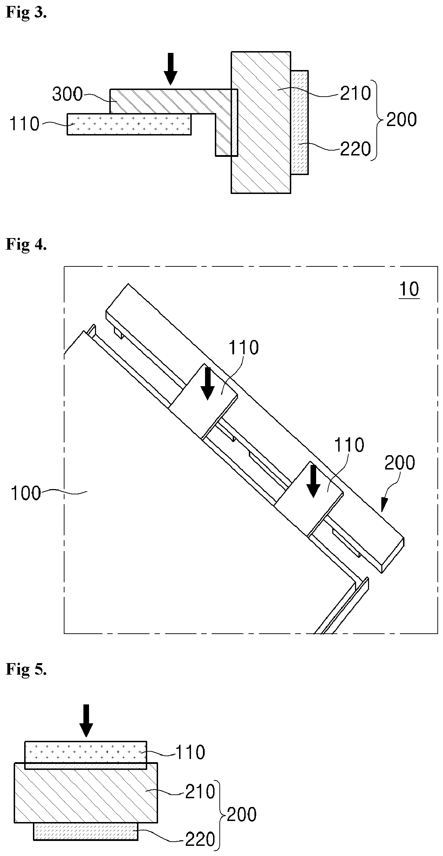

As illustrated in FIGS. 4 and 5, a battery pack connection structure in which the battery cell 100 is directly bonded with the PCM 200 in accordance with an exemplary embodiment includes the battery cell 100, the electrode lead tab 120 protruding from the battery cell 100, the PCB 210 that configures the PCM 200, and the protection circuit element.

FIG. 6 is an exploded cross-sectional view of the FIG. 5. As illustrated in FIG. 6, the PCB 210 in accordance with an exemplary embodiment is configured such that the second copper foil layer 213 and the third copper foil layer 214 are respectively formed on top and bottom surfaces of the insulation board 211, and the first copper foil layer 212 and the fourth copper foil layer 215 are respectively formed above the second copper foil layer 213 and below the third copper foil layer 214. Also, the first prepreg 216 containing the carbon black is disposed between the first copper foil layer 212 and the second copper foil layer 213, and the second prepreg 217 is disposed between the third copper foil layer 214 and the fourth copper foil layer 215.

The electrode lead tab 120 of the battery cell 100 and the first copper foil layer 212 of the PCB 210 are coupled through a bonding method using laser, and here, the laser has a wavelength band of 1070 µm. Since the prepreg in accordance with an exemplary embodiment includes the carbon black having a feature of absorbing the laser having the above-described wavelength band, the laser irradiated to the PCB 210 during laser welding is absorbed by the first prepreg 216 instead of being transmitted to a bottom surface of the first prepreg. Thus, the inner layer of the PCB 210 including the second copper foil layer 213 and the protection circuit element 220 mounted to the PCB 210 are not damaged.

The battery pack connection structure in which the battery cell 100 is directly bonded to the PCM 200 in accordance with an exemplary embodiment is configured such that the electrode lead tab 120 of the battery cell 100 and the first copper foil layer 212 of the PCB 210 are directly bonded to each other instead of including the separate connection member 300 that is described in the related art. Thus, since the connection member 300 and the process of mounting the connection member 300 to the first copper foil layer 212 are not required, the total volume of the battery pack may be reduced as the thickness and the structure of the connected portion are simplified as many as the volume of the connection member 300 excluded in the bonding process, and the entire assembling process of the battery pack for bonding the battery cell and the PCM 200 may be simplified.

Main reference numerals and terms thereof used in the drawings in accordance with an exemplary embodiment will be described below.
10: Battery pack
100: Battery cell
110: Battery cell main body
120: Electrode lead tab
200: PCM
210: PCB
211: Insulation board
212: First copper foil layer
213: Second copper foil layer
214: Third copper foil layer
215: Fourth copper foil layer
216: First prepreg layer
217: Second prepreg layer
220: Protection circuit element
300: Connection member

## Claims

1. A connection structure between a battery and a PCM in a battery pack in which a battery cell is connected to the PCM,
wherein the battery cell comprises:
a battery cell main body; and
an electrode lead tab electrically connected with the battery cell main body,
wherein a PCB of the PCM comprises:
an insulation board;
a second copper foil layer brought into contact with a top surface of the insulation board;
a first copper foil layer formed above the second copper foil layer; and
a first prepreg layer disposed between the first copper foil layer and the second copper foil layer,
wherein the electrode lead tab of the battery cell is directly bonded to the first copper foil layer of the PCM.

2. The connection structure of claim 1, wherein the direct bonding between the electrode lead tab of the battery cell and the PCM is formed by laser welding.

3. The connection structure of claim 2, wherein the first prepreg layer comprises a material having a high absorptance at a wavelength band of laser used in the laser welding.

4. The connection structure of claim 3, wherein the material having the high absorptance at the wavelength band of the laser used in the laser welding and contained in the first prepreg layer is carbon black.

5. The connection structure of claim 1, wherein the PCB comprises:
a third copper foil layer brought into contact with a bottom surface of the insulation board;
a fourth copper foil layer disposed below the third copper foil layer; and
a second prepreg layer disposed between the third copper foil layer and the fourth copper foil layer,
wherein the second prepreg layer comprises carbon black.

6. A battery pack comprising the PCM having the connection structure of any one of claims 1 to 5.
